# EUROPEAN PATENT APPLICATION

(11) **EP 2 249 388 A2**
(43) Date of publication of application: **10.11.2010**
(21) Application number: 10173659.3
(22) Date of filing: 04.05.2000
(51) Int. Cl.: H01L 27/146

(54) **Photo diode array**

(30) Priority: 11.05.1999 JP 12993399
(62) Divisional of application: 00109551.2
(71) Applicant: Yokogawa Electric Corporation, Musashino-shi 180-8750 Tokyo (JP)
(72) Inventor: Komiyama, Makoto, Tokyo 180-8750 (JP); Sanpei, Yoshihito, Tokyo 180-8750 (JP); Miura, Akira, Tokyo 180-8750 (JP); Sakakibara, Katsutoshi, Tokyo 180-8750 (JP); Yakihara, Tsuyoshi, Tokyo 180-8750 (JP); Fujita, Tadashige, Tokyo 180-8750 (JP); Kobayashi, Shinji, Tokyo 180-8750 (JP); Oka, Sadaharu, Tokyo 180-8750 (JP); Akasaka, Yasukazu, Tokyo 180-8750 (JP)
(74) Representative: Henkel, Feiler & Hänzel

(57) **Abstract**

A photo diode array whose linearity can be improved is realized.

In a photo diode array, a plurality of photo diodes arranged in the form of an array and a plurality of electrodes connected to both ends of the light-receiving surface of each photo diode, which take out a current generated in each of these photo diodes, are provided.

## Description

### BACKGROUND OF THE INVENTION

### 1. Field of the Invention

The present invention relates to a photo diode array, and in particular, to a photo diode array whose linearity can be improved.

### 2. Description of the Prior Art

A photo diode is formed by making a PN junction with a p-type region on the light-receiving surface side and an n-type region on the substrate side, and a current generated by the light incident from the photo sensitive area flows from the cathode to the anode.

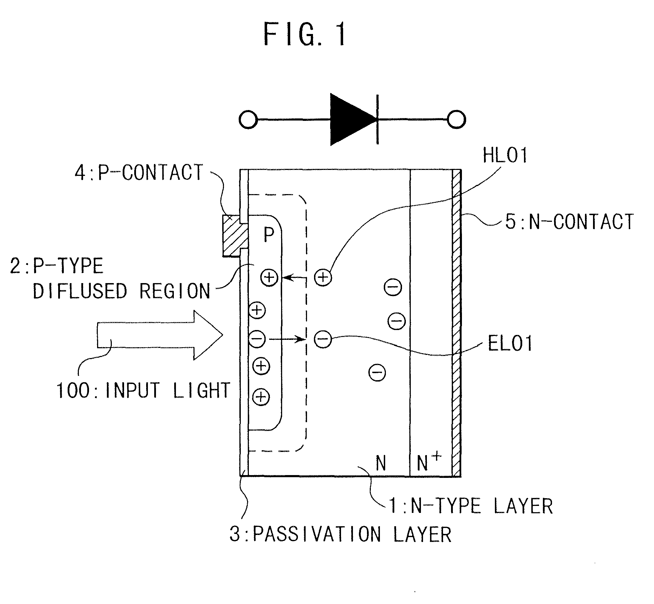

Figure 1 shows a sectional view of the configuration indicating an example of such conventional photo diodes. A p-type diffused region 2 is formed on one side of n-type layer 1, the substrate, n-contact 5 is formed on the opposite side of n-type layer 1, and passivation layer 3 is formed on the light-receiving surface side where p-type diffused region 2 is formed. A p-contact 4 connected to p-type diffused region 2 is formed by removing part of passivation layer 3 using etching or the like.

Operation of a conventional photo diode shown in Figure 1 will be described below. Electrons generated in the photo diode by input light 100 incident from the photo sensitive area are accumulated in n-type layer 1, while holes are accumulated in p-type diffused region 2. Accordingly, n-type layer 1 is negatively charged and p-type diffused region 2 is positively charged. Thus, if an external circuit is connected between p-type diffused region 2 and n-type layer 1, electrons and holes flow toward the opposite layers from n-type layer 1 and p-type diffused region 2 respectively.

For example, an electron generated in p-type diffused region 2 shown as "EL01" in Figure 1 is accelerated towards n-type layer 1 by the electric field in the photo diode and accumulated there. In a similar manner, a hole generated in n-type layer 1 shown as "HL01" in Figure 1 is accelerated towards p-type diffused region 2 and accumulated there.

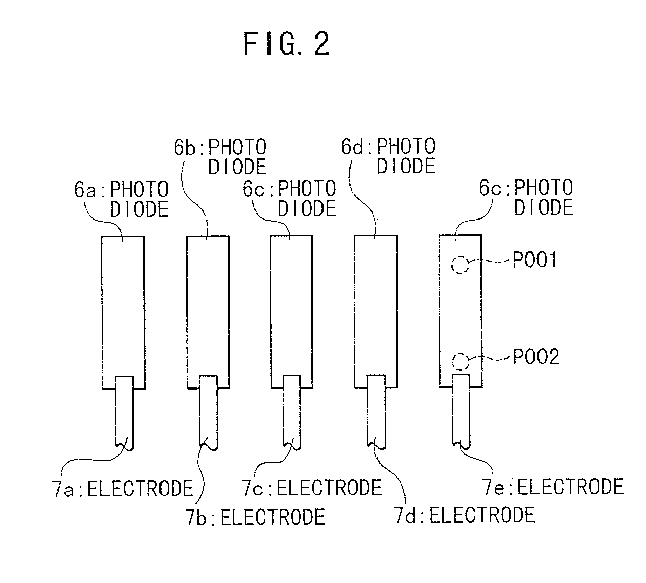

A photo diode array is composed of multiple such photo diodes arranged forming an array. Figure 2 shows a plan indicating an example of such a conventional photo diode array.

Photo diodes 6a to 6e are arranged forming an array on a substrate (not shown) so that their photo sensitive area are oriented to a direction and electrodes 7a to 7e are connected to one end of the photo sensitive area of photo diodes 6a to 6e respectively.

Here, operation of the example of the conventional photo diode array shown in Figure 2 will be described. If light is incident to the photo sensitive area of photo diodes 6a to 6e, currents are generated between each light-receiving surface side and each opposite side and these currents are taken out to the outside via electrodes 7a to 7e, respectively.

For example, in the example shown in Figure 2, holes generated in photo diodes 6a to 6e are taken out via electrodes 7a to 7e.

However, in the example of conventional photo diodes shown in Figure 2, current values taken out may vary due to the incident positions of input light. For instance, if the input light is incident to a portion marked "P001" in Figure 2, the distance from that portion to electrode 7e is longer compared with the case where the input light is incident to the portion marked "P002" in Figure 2.

This causes a voltage drop due to a resistance component that exists between the above portion and the electrode, and so the current value taken out to the outside changes. In other words, a problem exists that linearity deteriorates depending on the incident positions of the input light. Specifically, if a high current is generated by the light incident to the portion marked "P001" in Figure 2, linearity deterioration increases because the generated voltage drop further increases.

In order to reduce this linearity deterioration, a bias voltage forming a reverse bias is generally applied to the photo diode. However, although application of a bias voltage serves to improve the frequency response and linearity, a problem exists that this causes an increase in dark current and so increases the noise, and also has the danger of breaking the photo diode.

### SUMMARY OF THE INVENTION

The subject of the present invention is to realize a photo diode array in which linearity can be improved.

### BRIEF DESCRIPTION OF THE DRAWINGS

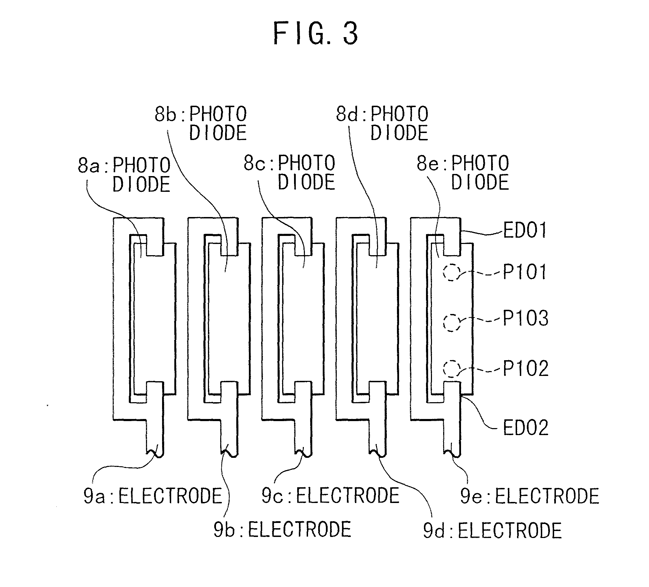

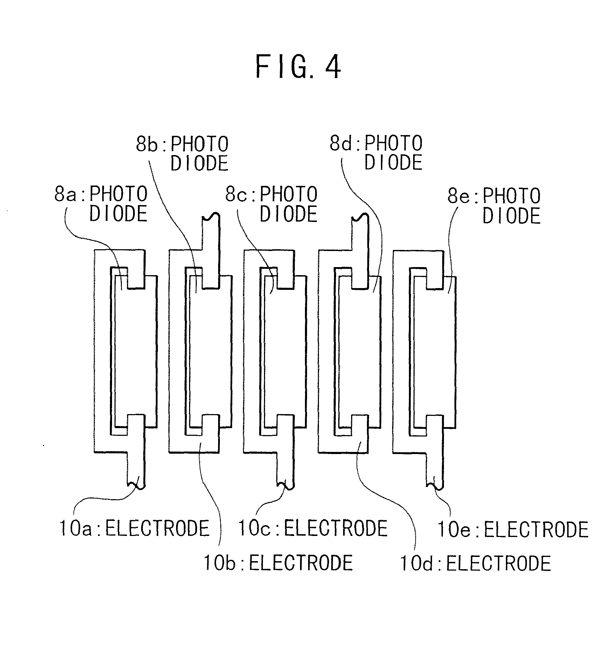

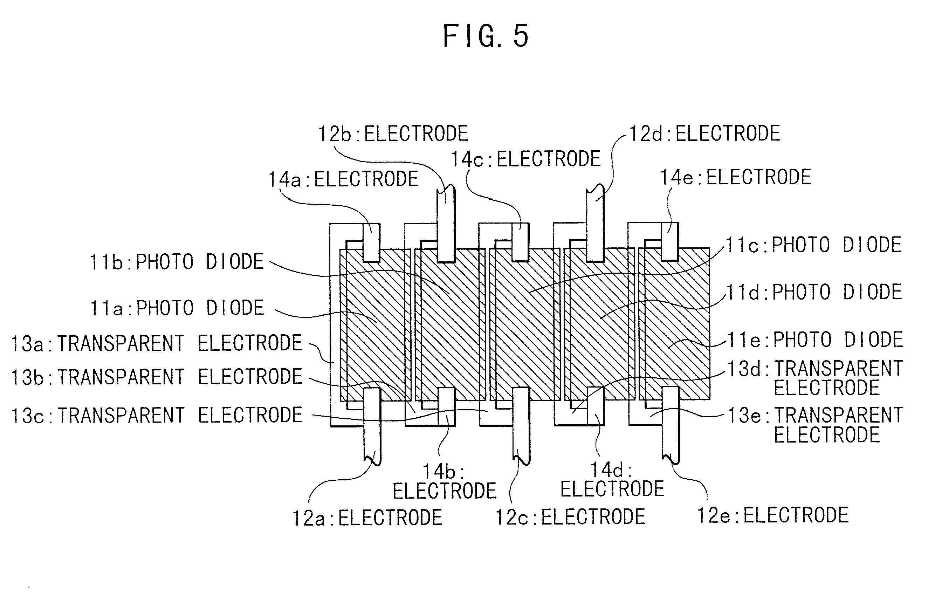

Figure 1 shows a sectional view of the configuration indicating an example of conventional photo diodes. Figure 2 shows a plan indicating an example of conventional photo diode arrays. Figure 3 shows a plan indicating an embodiment of a photo diode array based on the present invention. Figure 4 shows a plan indicating the second embodiment of a photo diode array based on the present invention. Figure 5 shows a plan indicating the third embodiment of a photo diode array based on the present invention.

### DETAILED DESCRIPTION OF THE PREFERRED EMBODIMENT

The present invention will be described below in detail using drawings. Figure 3 shows a plan indicating an embodiment of photo diode array based on the present invention.

Photo diodes 8a to 8e are arranged on a substrate (not shown) forming an array so that their photo sensitive area are oriented to a direction. Electrodes 9a to 9e are connected to one end of the photo sensitive area of photo diodes 8a to 8e respectively and also connected to the other end of the photo sensitive area of photo diodes 8a to 8e respectively by extending the electrodes between the photo sensitive area of two adjacent diodes.

In addition, electrodes 9a to 9e connected to both ends of photo sensitive area photo diodes 8a to 8e respectively are wired on the substrate in a direction downwards in Figure 3 to be led out to the outside.

Operation of the photo diode array of the embodiment shown in Figure 3 will be described. Since this array is configured to take currents out of both ends of each photo sensitive area of photo diodes 8a to 8e, respective distances from incident positions of the input light to electrodes 9a to 9e are shortened compared with those in examples of conventional photo diode arrays. Thus, the effect of resistance components that exist between the electrodes and the corresponding incident positions is reduced. In other words, deterioration of linearity can be reduced.

For example, if the input light is incident to the portion marked "P101" in Figure 3, the distance from the portion of "P101" to electrode 9e is that from the portion of "P101" to the connecting portion marked "ED01" in Figure 3. On the other hand, if the input light is incident to the portion marked "P102" in Figure 3, the distance from the portion of "P102" to electrode 9e is that from the portion of "P102" to the connecting portion marked "ED02" in Figure 3. That is, in both cases where the input light is incident to the portions marked "P101" and "P102" in Figure 3, the distances to electrode 9e are the same.

In addition, even if the input light is incident to the portion located at the center of the photo diode marked "P103," the distance between this portion and electrode 9e becomes approximately 1/2 compared with that in an example of the conventional array shown in Figure 2. Since this distance represents the maximum between the input light incident portion and the electrode in that photo diode, even in the worst case, deterioration of linearity can be reduced by about 1/2.

As a result, adoption of the configuration in which current is taken out of both ends of the photo sensitive area of photo diodes 8a to 8e shortens the distances between the input light incident portions and electrodes 9a to 9e respectively and so enables deterioration of linearity to be reduced.

In the embodiment shown in Figure 3, there is only one lead-out direction of electrodes 9a to 9e (towards the bottom of Figure 3). However, this lead-out can be done in both directions (towards the top and bottom of the figure). Figure 4 shows a plan indicating the second embodiment of a photo diode array of the present invention, in which the electrode lead-out direction is modified.

Photo diodes 8a to 8e are arranged forming an array on a substrate (not shown) so that the light-receiving surfaces face to this side. Electrodes 10a to 10e are connected to one end of the photo sensitive area of photo diodes 8a to 8e respectively as well as connected to the other ends of the photo sensitive area of photo diodes 8a to 8e respectively by extending the electrodes between adjacent photo diodes.

Further, electrodes 10a, 10c, and 10e connected to both ends of the photo sensitive area of photo diodes 8a, 8c, and 8e respectively are extended on the substrate towards the bottom of Figure 4 to be led out to the outside, while electrodes 10b and 10d connected to both ends of the photo sensitive area photo diodes 8b and 8d respectively are extended on the substrate towards the top of Figure 4 to be led out to the outside.

Operation of the photo diode array of the embodiment shown in Figure 4 will be described below. However, the basic operation is the same as in the embodiment shown in Figure 3 and the differences are as follows:

By alternately changing the electrode lead-out direction, wiring to the electrodes becomes easy in the case where it is difficult to secure wiring spaces for the electrodes from which the current signals are led out to the outside because the photo diodes are arranged in a highly dense manner.

In addition, in the embodiment shown in Figure 4, the electrode lead-out direction is changed alternately (every other electrode). However, the method of determining the electrode lead-out direction is not limited to the above but any number of electrodes may be led out in both directions. The lead-out direction may be changed regularly, for example, for every two electrodes, three electrodes, etc. The lead-out direction may also be changed irregularly.

As a result, wiring to the electrodes becomes easy because wiring spaces for the electrodes are secured by leading out the electrodes from both ends of the photo sensitive area of the electrodes.

In another case, the electrodes extended between adjacent photo diodes may be made transparent to secure the photo sensitive area of those portions of the photo diodes. Figure 5 shows a plan indicating the third embodiment of a photo diode array of the present invention using such transparent electrodes in part of the array.

Photo diodes 11a to 11e are arranged forming an array on a substrate (not shown) so that the light-receiving surfaces face to this side. Electrodes 12a to 12e are connected to one end of the photo sensitive area of photo diodes 11a to 11e and electrodes 14a to 14e to the other ends of photo diodes 11a to 11e respectively.

Further, electrodes 12a and 14a are connected to each other by transparent electrode extension 13a located between adjacent photo diodes, and electrodes 12b and 14b are connected to each other by transparent electrode extension 13b located between adjacent photo diodes.

Electrodes 12c, 12d and 12e and electrodes 14c, 14d and 14e are connected to each other respectively by corresponding transparent electrodes 13c, 13d and 13e extended between adjacent photo diodes.

Further, electrodes 12a, 1.2c and 12e connected to one end of each photo sensitive area of photo diodes 11a, 11e and 11e respectively are wired on the substrate to lead out to the outside towards the bottom of Figure 5. Electrodes 12b and 12d connected to one end of each photo sensitive area of photo diodes 11b and 11d respectively are wired on the substrate to lead out to the outside towards the top of Figure 5.

Operation of the photo diode array of the embodiment shown in Figure 5 will be described below. However, the basic operation is the same as in the embodiment shown in Figure 3 and the differences are as follows:

By making electrodes extended between adjacent photo diodes transparent, the light-receiving areas of the photo diodes can be increased compared with the embodiments shown in Figures 3 and 4 because these transparent electrode extensions may overlap with the photo diodes.

As a result, by employing the transparent electrode extensions between the adjacent photo diodes, it becomes possible to enlarge the photo sensitive area of each photo diode.

In addition, in each embodiment shown in Figures 3, 4 and 5, five photo diodes are shown as an example for simplicity of description. However, the number of photo diodes is, of course, not limited to this number but the present invention can be applied to any photo diode array using any number of photo diodes.

Also, in the embodiments shown in Figures 3, 4 and 5, electrode extensions connecting both ends of the photo sensitive area of photo diodes respectively are passed between the target photo diodes and the next photo diodes on the left side of the target photo diodes respectively. However, electrode extensions connecting both ends of the photo sensitive area of photo diodes respectively may of course be passed between the target photo diodes and the next photo diodes on the right side of the target photo diodes respectively.

Further, in the embodiment shown in Figure 5, an example of electrodes that are led out in both directions alternately is shown. However, the electrodes may of course be led out in one direction only or alternately for every two electrodes in both directions or irregularly in both directions.

As is apparent from the description above, the present invention has the following effects:
According to the invention described in claims 1, 2 and 5, the distance between the input light incident position and the electrodes is shortened by employing the configuration in which currents are taken out from both ends of each photo sensitive area of every photo diode. Thus, it becomes possible to reduce deterioration of linearity.
   In addition, according to the invention described in claims 3 and 4, it becomes possible to increase the photo sensitive area of the photo diode portion by making the electrodes extended between adjacent photo diodes transparent.
According to the invention described in claims 6, 7 and 8, wiring to the electrodes becomes easy by leading out the electrodes in both directions from the photo sensitive area of photo diodes because spaces for wiring to the electrodes are secured.

## Claims

1. A photo diode array comprising:
a plurality of photo diodes (8a to 8e, 11a to 11e) arranged forming an array; and
a plurality of electrodes (9a to 9e, 10a to 10e) that are connected to the photo sensitive area of these photo diodes (8a to 8e, 11a to 11e) and take out currents generated in the above photo diodes (8a to 8e, 11a to 11e);
**characterized in that**
each electrode (9a to 9e, 10a to 10e) consists of two connection portions (ED01, ED02) and an electrode extension connecting the above two connection portions (9a to 9e, 10a to 10e); and
each of the two connection portions (ED01, ED02) is connected to one respective end of the photo sensitive area of the photo diode (8a to 8e, 11a to 11e).

2. A photo diode array in accordance with claim 1, **characterized in that** the electrode extensions are located between adjacent photo sensitive areas of the photo diodes (8a to 8e, 11a to 11e).

3. A photo diode array in accordance with claims 1 and 2, **characterized in that** there is only one lead-out direction of said electrodes (9a to 9e, 10a to 10e), from the photo sensitive area of the photo diodes (8a to 8e, 11a to 11e).

4. A photo diode array in accordance with claims 1 to 3, **characterized in that** the lead-out direction of said electrodes (9a to 9e, 10a to 10e) is in both directions from one end and the other end of said photo sensitive area of the photo diodes (8a to 8e, 11a to 11e).

5. A photo diode array in accordance with claim 1, **characterized in that** said electrodes (9a to 9e, 10a to 10e) are led out alternately in both directions from both ends of said photo sensitive area of the photo diodes (8a to 8e, 11a to 11e).

6. A photo diode array in accordance with claim 5, **characterized in that** said electrodes (9a to 9e, 10a to 10e) are led out repeatedly in the following manner:
in one direction from each end of said photo sensitive area of the photo diodes(8a to 8e, 11a to 11e), and
next in the other direction from the other end of one of said photo sensitive area of the photo diodes (8a to 8e, 11a to 11e).
